# EUROPEAN PATENT SPECIFICATION

(11) **EP 1 269 513 B1**
(45) Date of publication and mention of the grant of the patent: **17.10.2007**
(21) Application number: 01920902.2
(22) Date of filing: 28.03.2001
(51) Int. Cl.: H01J 37/32

(54) **INDUCTIVELY COUPLED PLASMA ETCHING APPARATUS**
INDUKTIV GEKOPPELTES PLASMA-ÄTZGERÄT
DISPOSITIF DE GRAVURE AU PLASMA A COUPLAGE INDUCTIF

(30) Priority: 31.03.2000 JP 2000099728; 30.06.2000 US 608883
(43) Date of publication of application: 02.01.2003
(73) Proprietor: LAM RESEARCH CORPORATION, Fremont, CA 94538-6470 (US)
(72) Inventor: NAKAJIMA, Shu, Chigasaki-shi, Kanagawa-ken 253-0001 (JP)
(74) Representative: Thomson, Paul Anthony
(86) International application number: PCT/US2001/010335
(87) International publication number: WO 2001/075931

(56) References cited:
- WO-A-99/53733
- US-A- 5 540 800
- US-A- 5 650 032
- US-A- 6 149 760
- PATENT ABSTRACTS OF JAPAN vol. 1999, no. 14, 22 December 1999 (1999-12-22) & JP 11 251303 A (TOKYO ELECTRON YAMANASHI LTD;JAPAN SCIENCE & TECHNOLOGY CORP), 17 September 1999 (1999-09-17)

## Description

### BACKGROUND OF THE INVENTION

The present invention relates generally to semiconductor fabrication and, more particularly, to an inductively coupled plasma etching apparatus and a method for controlling a chamber inner wall surface of an inductively coupled plasma etching apparatus.

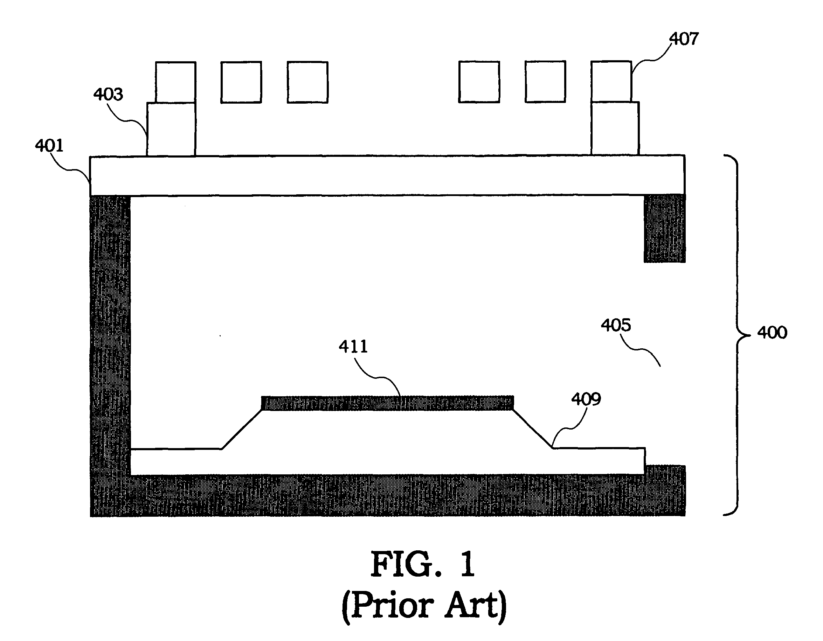

In semiconductor manufacturing processes, etching processes, insulation film formation, and diffusion processes are repeatedly carried out. As is well known to those skilled in the art, there are two types of etching processes: wet etching and dry etching. Dry etching is typically implemented by using an inductively coupled plasma etching apparatus such as shown in Figure 1.

In the inductively coupled plasma etching apparatus shown in Figure 1, a reactant gas is first led into chamber 400 through a gas lead-in port (not shown). High frequency power is then applied from a power supply (not shown) to coil 407. Semiconductor wafer 411 is mounted on chuck 409 provided inside chamber 400. Coil 407 is held on the upper portion of chamber by spacers 403, which are formed of an insulating material. In operation, high frequency (RF) current passing through coil 407 induces an electromagnetic current into chamber 400, and the electromagnetic current acts on the reactant gas to generate a plasma.

The plasma contains various types of radicals and the chemical reaction of the positive/negative ions is used to etch semiconductor wafer 411 itself or an insulation film formed on the wafer. During the etching process, coil 407 carries out a function that corresponds to that of the primary coil of a transformer while the plasma in chamber 400 carries out a function that corresponds to that of the secondary coil of the transformer. The reaction product generated by the etching process is discarded via exhaust port 405.

When etching one of the recently developed device materials (e.g., platinum, ruthenium, and the like), the reaction product generated may be a nonvolatile substance (e.g., RuO₂). In some cases, the reaction product may adhere to wall 401 of chamber 400. If the reaction product is conductive, then the film of reaction product on wall 401 may electrically shield the electromagnetic current in the chamber. Consequently, the plasma does not strike after several wafers are etched and the etching process must be discontinued.

To avoid this problem, a method for sputtering the reaction product adhered to wall 401 by using the plasma has been developed. In the inductively coupled plasma etching apparatus shown in Figure 1, however, the electromagnetic current induced by the RF current generates a distribution voltage having a standing wave in the vicinity of wall 401. This is problematic because it causes the deposition and sputtering of the reaction product to become non-uniform. In particular, a relatively large amount of energy is added to the plasma in the region where the amplitude of the standing wave is high. Consequently, the reaction product is excessively sputtered in this region. On the other hand, only a relatively small amount of energy is added to the plasma in the region where the amplitude of the standing wave is low, i.e., the region in the vicinity of the node of the standing wave. As a result, the reaction product is deposited in this region. As discussed above, the presence of an electrically conductive film on wall 401 is undesirable because it can electrically shield the electromagnetic current in the chamber and thereby disable the etching process.

In view of the foregoing, there is a need for an inductively coupled plasma etching apparatus that prevents substantial deposition of electrically conductive reaction products on the surface of a chamber inner wall.

An example of a prior art arrangement is disclosed in US 5 650 032 A (John Howard Keller et al).

### SUMMARY OF THE INVENTION

Broadly speaking, the present invention provides an inductively coupled plasma etching apparatus that uniformly adds energy to the plasma in the vicinity of a wall of the chamber in which the plasma is generated.

In accordance with one aspect of the present invention, an inductively coupled plasma etching apparatus is provided as set forth in the appended claims.

The present invention advantageously prevents the deposition of electrically conductive reaction products, e.g. RuO₂, on the inner surface of the wall of a chamber in an inductively coupled plasma etching apparatus. This makes it possible to plasma etch recently developed device materials, e.g., Ru, without having to stop the plasma etching operation to clean the walls of the chamber after only a few wafers have been processed.

It is to be understood that the foregoing general description and the following detailed description are exemplary and explanatory only and are not restrictive of the invention, as claimed.

### BRIEF DESCRIPTION OF THE DRAWINGS

The accompanying drawings, which are incorporated in and constitute part of this specification, illustrate exemplary embodiments of the invention and together with the description serve to explain the principles of the invention.
Figure 1 is a simplified schematic cross-section showing a prior art inductively coupled plasma etching apparatus.
Figure 2 is a simplified schematic cross-section showing an inductively coupled plasma etching apparatus in accordance with one embodiment of the present invention.
Figure 3 is an exploded perspective view of a metal plate, which acts as a Faraday shield, and the components for holding the metal plate in place in accordance with one embodiment of the present invention.
Figure 4 is an exploded perspective view of a coil and the components for holding the coil in place in accordance with one embodiment of the present invention.

### DETAILED DESCRIPTION OF THE INVENTION

Several exemplary embodiments of the invention will now be described in detail with reference to the accompanying drawings. Figure 1 is discussed above in the "Background of the Invention" section.

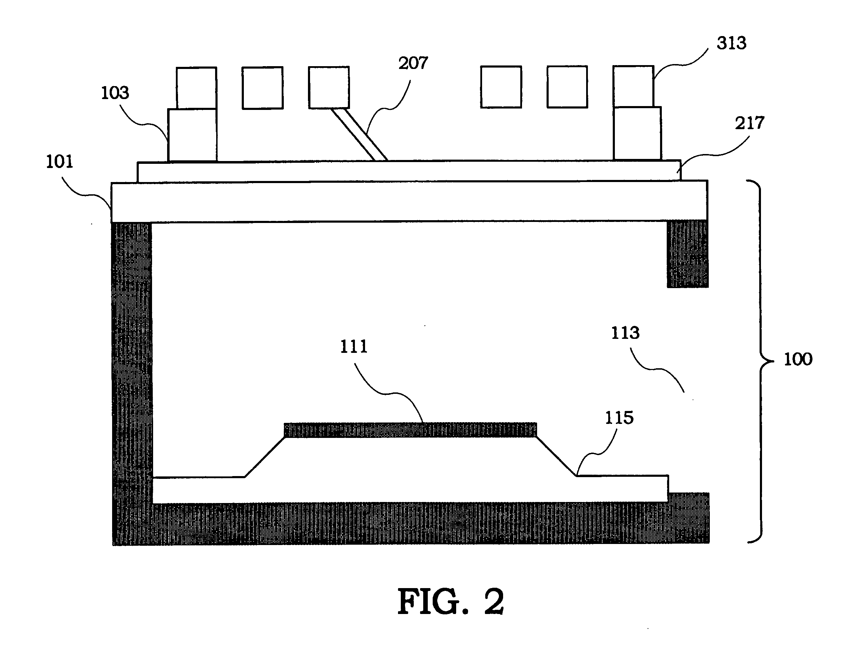

Figure 2 is a simplified schematic cross-section showing an inductively coupled plasma etching apparatus in accordance with one embodiment of the present invention. As shown in Figure 2, semiconductor wafer 111 is mounted on chuck 115 disposed in chamber 100, which is defined by walls of a housing, proximate to a lower wall of the housing. Coil 313 is supported on upper wall 101 of chamber 100 by spacers 203, which may be formed of an insulating material. In operation, a reactant gas is fed into chamber 100 through a gas lead-in port (not shown). High frequency power from a power supply (not shown) is applied to coil 313. The high frequency (RF) current passing through coil 313 induces an electromagnetic current in chamber 100, and the electromagnetic current acts on the reactant gas to generate a plasma.

The plasma contains various types of radicals and the chemical reaction of the positive/negative ions is used to etch semiconductor wafer 111 itself or an insulation film formed on the wafer. During the etching process, coil 313 carries out a function that corresponds to that of the primary coil of a transformer while the plasma in chamber 100 carries out a function that corresponds to that of the secondary coil of the transformer. If the reaction product generated by the etching process is volatile, then this reaction product is discarded via exhaust port 113.

Metal plate 217, which acts as a Faraday shield, is provided between coil 313 and chamber 100. In one embodiment, metal plate 217 is positioned in a spaced apart between coil 313 and upper wall 101 of the housing and is substantially parallel to upper wall 101. The thickness of metal plate 217 is preferably between about 20 µm and about 10 mm, and more preferably between about 50 µm and about 5 mm. In one embodiment, metal plate 217 has a thickness of about 1.5 mm. Connector 207 electrically connects metal plate 217 to coil 313 at a predetermined position of the coil and functions to ensure that the in-plane RF voltage applied to metal plate 217 is uniform. Because the in-plane RF voltage applied to metal plate 217 is uniform, energy is uniformly added to the plasma in the vicinity of upper wall 101. As a result of this uniform energy distribution, the deposition and sputtering of the reaction product occurs uniformly so that undesirable accumulation of the reaction product on upper wall 101 does not occur.

In one embodiment, connector 207 electrically connects metal plate 217 to coil 313 at a position so that adequate Vₚₚ (peak-to-peak voltage) is applied on the metal plate. By uniformly applying Vₚₚ on metal plate 217, ions in the plasma are accelerated and uniformly bombard the vacuum side surface of a wall of the chamber of the inductively coupled plasma etching apparatus to prevent deposition of the reaction product thereon. In one embodiment, the inductively coupled plasma etching apparatus is a TCP 9400 PTX plasma etching apparatus, which is commercially available from Lam Research Corporation of Fremont, California, and the accelerated ions uniformly bombard the vacuum side surface of the TCP window to prevent deposition of the reaction product thereon. In an alternative embodiment, connector 207 electrically connects metal plate to a conductor extending from an impedance matching box to the coil.

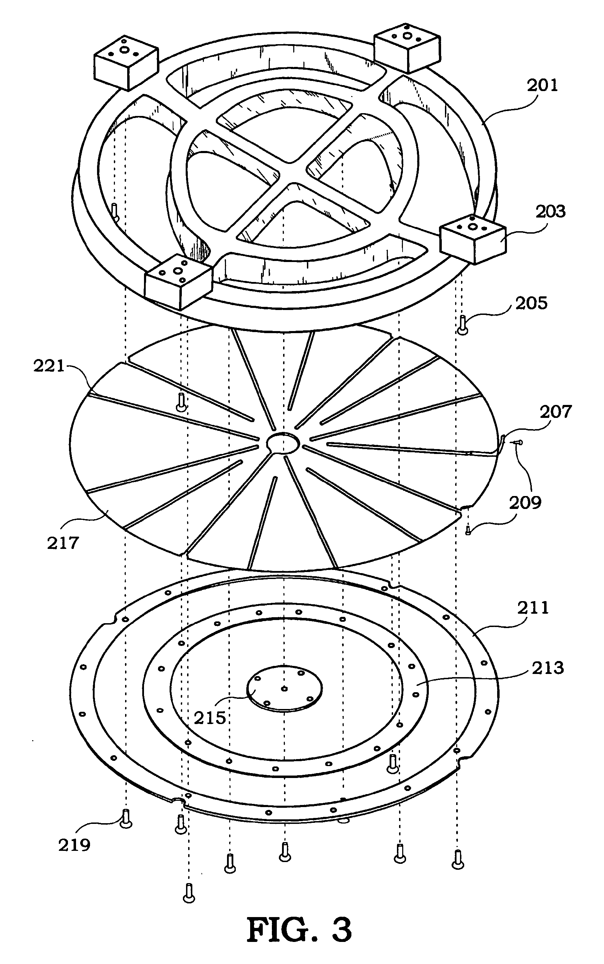

Figure 3 is an exploded perspective view of the metal plate, which acts as a Faraday shield, and the components for holding the metal plate in place in accordance with one embodiment of the invention. As shown in Figure 3, metal plate 217 is secured to the underside of attachment frame 201, which is provided with attachment spacers 203 on a top side thereof, by screws 205. Attachment frame 201, attachment spacers 203, and screws 205 may be formed of any suitable insulating material.

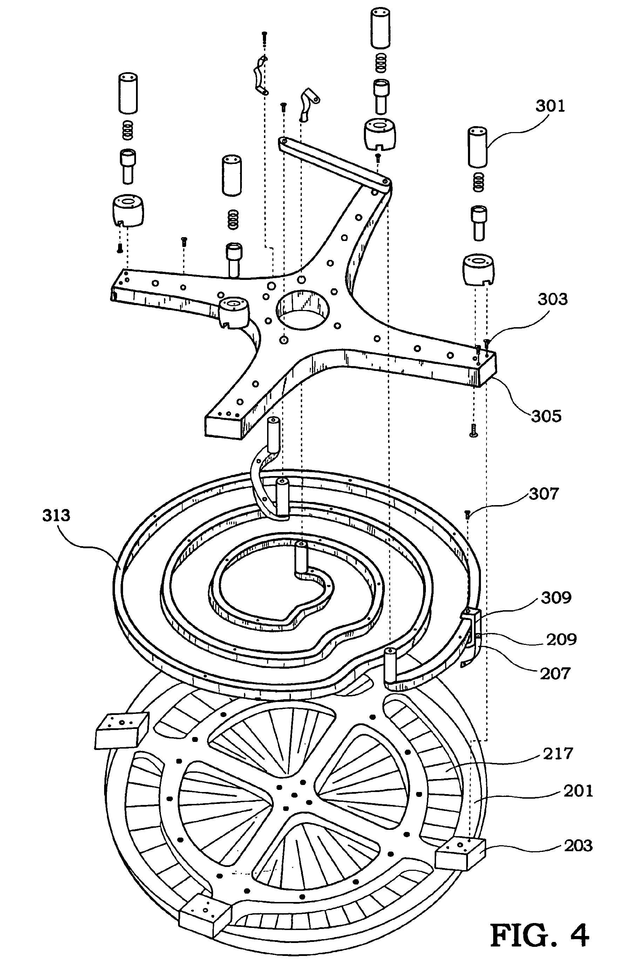

Outer ring 211, inner ring 213, and center disk 215 are secured to attachment frame 201 by screws 219, which may be formed of any suitable insulating material. Outer ring 211, inner ring 213, and center disk 215 retain the shape of metal plate 217 during operation of the inductively coupled plasma etching apparatus. A plurality of radial slots 221 is formed in metal plate 217. Radial slots 221 extend transversely to the sections of coil 313 (see Figure 4) to interrupt an internal induced power generated by electric current from flowing on metal plate 217, which is a conductor. This is necessary because electric current flowing on metal plate 217 causes coil 313 (see Figures 2 and 4) and chamber 100 (see Figure 2) to be electrically shielded.

With continuing reference to Figure 3, connector 207 electrically connects metal plate 217 and coil 313 (see Figures 2 and 4). Two metal screws 209 are used to make this connection, with one metal screw connecting metal plate 217 to connector 207 and the other metal screw connecting coil 313 (see Figures 2 and 4) to connector 207.

Figure 4 is an exploded perspective view of the coil and the components for holding the coil in place in accordance with one embodiment of the invention. As shown in Figure 4, attachment frame 201 and attachment spacers 203 are provided between metal plate 217 and coil 313. The four ends of cross-shaped coil mounting plate 305 are fixed by support spring housings 301 and metal screws 303 to retain the shape of coil 313. As shown in Figure 4, coil 313 has three turns. Coil 313 must have at least one turn, but otherwise may have any suitable number of turns.

As discussed above in connection with the description of Figure 3, connector 207 electrically connects metal plate 217 to coil 313. As shown in Figure 4, a U-shaped spacer 309 positions coil mounting plate 305, coil 313, and metal plate 217. U-shaped spacer 309 is connected to coil 313 by metal screw 307. One metal screw 209 electrically connects connector 207 to coil 313 through U-shaped spacer 309 and another metal screw 209 electrically connects connector 207 to metal plate 217 (see Figure 3).

The inductively coupled plasma etching apparatus of the present invention is well suited for plasma etching of recently developed device materials (e.g., platinum, ruthenium, and the like) that generate nonvolatile, electrically conductive reaction products (e.g., RuO₂). It will be apparent to those skilled in the art that the inductively coupled plasma etching apparatus of the present invention also may be used to plasma etch standard materials such as metal and polysilicon. In the plasma etching of metal and polysilicon, Vₚₚ is adjusted to realize uniform and minimum deposition. In this manner, the mean wafer between clean (MWBC) and the lifetime of the TCP window may be improved.

In summary, the present invention provides an inductively coupled plasma etching apparatus for controlling an inner surface of a wall defining a chamber in which a plasma is generated. The invention has been described herein in terms of several preferred embodiments. Other embodiments of the invention will be apparent to those skilled in the art from consideration of the specification and practice of the invention. For example, the shape of the metal plate, which acts as a Faraday shield, and the positional relationship between the metal plate and the chamber may be varied in accordance with the inductively coupled plasma etching apparatus adopting the present invention. The embodiments and preferred features described above should be considered exemplary, with the scope of the invention being defined by the appended claims and their equivalents.

## Claims

1. An inductively coupled plasma etching apparatus, comprising:
a chamber (100) for generating a plasma therein, the chamber being defined by walls of a housing;
a coil (313) for receiving high frequency (RF) power disposed adjacent to and outside of one of the walls of the housing;
a metal plate (217) disposed adjacent to and outside of the wall of the housing that the coil is disposed adjacent to, the metal plate being positioned in a spaced apart relationship between the coil and the wall of the housing and having radial slits formed therein that extend transversely to the coil; and
a connector (207) electrically connecting the metal plate (217) to the coil (313), **characterized in that** the metal plate is secured to an underside of an attachment frame (201).

2. The apparatus of claim 1, wherein a chuck (115) for holding a semiconductor wafer (111) is disposed proximate to a lower wall of the housing, and the metal plate is disposed along a surface of an upper wall of the housing.

3. The apparatus of claim 1, wherein the metal plate (217) is substantially parallel to the upper wall of the housing.

4. The apparatus of claim 1, wherein a thickness of the metal plate (217) is in a range from about 20 µm to about 10 mm.

5. The apparatus of claim 1, wherein a thickness of the metal plate (217) is in a range from about 50 µm to about 5mm.

6. The apparatus of claim 1, wherein a thickness of the metal plate (217) is about 1.5 mm.

7. The apparatus of claim 1, wherein the connector (207) electrically connects the metal plate (217) to one of a predetermined position of the coil (313) or to a conductor extending from an impedance matching box to the coil.

8. The apparatus of claim 1, wherein the metal plate (217) is secured to the underside of the attachment frame (201) by an outer ring (211), an inner ring (213), and a center disk (215).

9. The apparatus of claim 8, wherein the attachment frame (201) includes attachment spacers (203) on a top side thereof, and the attachment frame and the attachment spacers are comprised of an insulating material.

10. The apparatus of claim 9, wherein the coil (313) is positioned between the top side of the attachment frame (201) and a coil mounting plate (305), and the coil mounting plate (305) is secured to the attachment spacers.

11. The apparatus of claim 10, wherein a U-shaped spaced (309) positions the coil mounting plate (305), the coil (313) and the metal plate (217), and the connector (207) electrically connects the metal plate (217) to the coil (313) through the U-shaped spacer (309).

## Patentansprüche

1. Induktiv gekoppeltes Plasma-Ätzgerät, umfassend:
eine Kammer (100), um ein Plasma darin zu erzeugen, wobei die Kammer von Wänden eines Gehäuses umschlossen ist;
eine Spule (313) zum Empfangen von Hochfrequenzleistung (RF), die angrenzend zu und außerhalb einer der Wände des Gehäuses angeordnet ist;
eine Metallplatte (217), die angrenzend zu und außerhalb derjenigen Wand des Gehäuses, an die die Spule angrenzt, angeordnet ist, wobei die Metallplatte mit einer beanstandeten Anordnungsbeziehung zwischen der Spule und der Wand des Gehäuses platziert ist und in ihr ausgebildete radiale Schlitze aufweist, die sich quer zu der Spule erstrecken, und
einen Verbinder (207), der die Metallplatte (217) elektrisch mit der Spule (313) verbindet,
**dadurch gekennzeichnet, dass** die Metallplatte (217) an der Unterseite eines Befestigungsrahmens (201) montiert ist.

2. Gerät nach Anspruch 1, **dadurch gekennzeichnet, dass** eine Spannvorrichtung (115) zum Halten eines Halbleiterwafers (111) benachbart zu einer unteren Wand des Gehäuses angeordnet ist, und dass die Metallplatte entlang einer Fläche einer oberen Wand des Gehäuses angeordnet ist.

3. Gerät nach Anspruch 1, **dadurch gekennzeichnet, dass** sich die Metallplatte (217) im Wesentlichen parallel zu der oberen Wand des Gehäuses erstreckt.

4. Gerät nach Anspruch 1, **dadurch gekennzeichnet, dass** die Dicke der Metallplatte (217) im Bereich von ungefähr 20 µm bis ungefähr 10 mm liegt.

5. Gerät nach Anspruch 1, **dadurch gekennzeichnet, dass** die Dicke der Metallplatte (217) im Bereich von ungefähr 50 µm bis ungefähr 5 mm liegt.

6. Gerät nach Anspruch 1, **dadurch gekennzeichnet, dass** die Dicke der Metallplatte (217) ungefähr 1,5 mm beträgt.

7. Gerät nach Anspruch 1, **dadurch gekennzeichnet, dass** der Verbinder (207) die Metallplatte (217) mit einer der vorbestimmten Positionen an der Spule (313) oder mit einem sich von einer Impedanzanpassungsbox zu der Spule erstreckenden Leiter elektrisch verbindet.

8. Gerät nach Anspruch 1, **dadurch gekennzeichnet, dass** die Metallplatte (217) durch einen äußeren Ring (211), einen inneren Ring (213) und eine Mittelscheibe (215) an der Unterseite des Befestigungsrahmens (201) befestigt ist.

9. Gerät nach Anspruch 8, **dadurch gekennzeichnet, dass** der Befestigungsrahmen (201) Befestigungsabstandsstücke (203) auf seiner Oberseite aufweist und dass der Befestigungsrahmen und die Befestigungsabstandsstücke aus einem isolierenden Material bestehen.

10. Gerät nach Anspruch 9, **dadurch gekennzeichnet, dass** die Spule (313) zwischen der Oberseite des Befestigungsrahmens (201) und einer Spulenmontageplatte (305) angeordnet ist und die Spulenmontageplatte (305) an den Befestigungsabstandsstücken befestigt ist.

11. Gerät nach Anspruch 10, **dadurch gekennzeichnet, dass** ein U-förmiges Abstandsstück (309) die Spulenmontageplatte (305), die Spule (313) und die Metallplatte (217) positioniert und dass der Verbinder (207) die Metallplatte (217) mit der Spule (313) durch das U-förmige Abstandsstück (309) elektrisch verbindet.

## Revendications

1. Appareil de gravure par plasma couplé de manière inductive, comprenant :
- une chambre (100) pour générer à l'intérieur un plasma, la chambre étant définie par les parois d'un logement ;
- une bobine (313) pour recevoir une énergie à haute fréquence (RF), disposée adjacente à, et à l'extérieur de, l'une des parois du logement ;
- une plaque métallique (217) disposée adjacente à, et à l'extérieur de, la paroi du logement auprès de laquelle est disposée de manière adjacente la bobine, la plaque métallique étant positionnée dans une relation espacée entre la bobine et la paroi du logement et présentant des fentes radiales formées à l'intérieur qui s'étendent de manière transversale à la bobine ; et
- un connecteur (207) qui connecte de manière électrique la plaque métallique (217) à la bobine (313), **caractérisé en ce que** la plaque métallique est fixée à un dessous d'un châssis de fixation (201).

2. Appareil selon la revendication 1, dans lequel un support de tranche (115) destiné à tenir une tranche de semi-conducteur (111) est disposé à proximité d'une paroi inférieure du logement, et la plaque métallique est disposée le long d'une surface d'une paroi supérieure du logement.

3. Appareil selon la revendication 1, dans lequel la plaque métallique (217) est sensiblement parallèle à la paroi supérieure du logement.

4. Appareil selon la revendication 1, dans lequel l'épaisseur de la plaque métallique (217) se situe dans une plage comprise entre 20 µm environ et 10 mm environ.

5. Appareil selon la revendication 1, dans lequel l'épaisseur de la plaque métallique (217) se situe dans une plage comprise entre 50 µm environ et 5mm environ.

6. Appareil selon la revendication 1, dans lequel la plaque métallique (217) présente un épaisseur d'environ 1,5 mm.

7. Appareil selon la revendication 1, dans lequel le connecteur (207) connecte de manière électrique la plaque métallique (217) à l'un d'une position prédéterminée de la bobine (313) ou d'un conducteur qui s'étend à partir d'un boîtier d'adaptation d'impédance jusqu'à la bobine.

8. Appareil selon la revendication 1, dans lequel la plaque métallique (217) est fixée à la face inférieure du châssis de fixation (201) par un anneau extérieur (211), un anneau intérieur (213), et un disque central (215).

9. Appareil selon la revendication 8, dans lequel le châssis de fixation (201) inclut des entretoises de fixation (203) sur un côté supérieur de celui-ci, et le châssis de fixation et les entretoises de fixation sont réalisées dans un matériau isolant.

10. Appareil selon la revendication 9, dans lequel la bobine (313) est positionnée entre le côté supérieur du châssis de fixation (201) et une plaque de support de bobine (305), et la plaque de support de bobine (305) est fixée aux entretoises de fixation.

11. Appareil selon la revendication 10, dans lequel une entretoise en forme de U (309) positionne la plaque de support de bobine (305), la bobine (313) et la plaque métallique (217), et le connecteur (207) connecte de manière électrique la plaque métallique (217) à la bobine (313) par l'intermédiaire de l'entretoise en forme de U (309).
